(19) **Europäisches Patentamt / European Patent Office / Office européen des brevets**

(11) **EP 1 349 268 B1**

(12) **EUROPEAN PATENT SPECIFICATION**

(45) Date of publication and mention
of the grant of the patent:
**02.12.2009  Bulletin 2009/49**

(51) Int Cl.:
***H03G 1/00*** (2006.01)

(21) Application number: **03013175.9**

(22) Date of filing: **12.04.2000**

(54) **MOS variable gain amplifier**

Variabler OS-Verstärker

Amplificateur MOS à gain variable

(84) Designated Contracting States:
**DE FR GB**

(30) Priority: **13.04.1999  US 129133 P**
**12.11.1999  US 439101**
**14.01.2000  US 483551**
**28.01.2000  US 493942**

(43) Date of publication of application:
**01.10.2003  Bulletin 2003/40**

(62) Document number(s) of the earlier application(s) in
accordance with Art. 76 EPC:
**00925949.0 / 1 177 621**

(73) Proprietor: **Broadcom Corporation**
**Irvine, CA 92617 (US)**

(72) Inventor: **Behzad, Arya**
**92064 Poway, CA (US)**

(74) Representative: **Jehle, Volker Armin et al**
**Bosch Jehle Patentanwaltsgesellschaft mbH**
**Flüggenstrasse 13**
**80639 München (DE)**

(56) References cited:
**EP-A- 0 365 085     WO-A-97/32393**
**US-A- 5 587 688**

**Description**

BACKGROUND OF THE INVENTION

Radio receivers, or tuners, are widely used in applications requiring the reception of electromagnetic energy. Applications can include broadcast receivers such as radio and television, set top boxes for cable television, receivers in local area networks, test and measurement equipment, radar receivers, air traffic control receivers, and microwave communication links among others. Transmission of the electromagnetic energy may be over a transmission line or by electromagnetic radio waves.

The design of a receiver is one of the most complex design tasks in electrical engineering. In the current state of the art, there are many design criteria that must be considered to produce a working radio receiver. Tradeoffs in the design's performance are often utilized to achieve a given objective. There are a multitude of performance characteristics that must be considered in designing the receiver.

However, certain performance characteristics are common to all receivers. Distortion and noise are two such parameters. The process of capturing the signal creates distortion that must be accounted for in the design of the radio receiver. The distortion must either be filtered out or canceled. Once a radio signal is captured, the noise surrounding the received signal in the receiver must be considered. Radio signals are often extremely weak and if noise is present in the circuit, the signal, even though satisfactorily received, can be easily lost in this noise floor. The current state of the art in receiver design is often directed to overcoming these receiver limitations in a cost effective manner.

In an integrated radio receiver ESD discharge circuitry is typically utilized to protect the integrated circuit from static discharge. Radio signals in a receiver tend to be of small amplitude and high frequency and are therefore susceptible to distortion caused by capacitive loading by standard ESD control methods. It is therefore desirable to provide a system of ESD protection that does not interfere with the reception of the high frequency, small amplitude signals.

Inductors are utilized in a receiver to provide frequency selectivity that helps eliminate distortion and interference. Inductors are not easily integrated onto a semiconductor substrate. Spiral inductors typically used have a low Q that provides insufficient selectivity, requiring filters to be fabricated off of the integrated circuit substrate.

Amplifiers are utilized to boost signal levels above the receiver noise floor. Amplification is used in many receiver functions. It is used in a fixed gain amplifier to provide a fixed gain to a signal presented to it. In providing a fixed gain a signal of a given power level presented to an amplifier is increased in power by a fixed multiplication factor. In a variable gain amplifier ("VGA") gain is often adjusted to provide an output signal of fixed power for a variety of input signal power levels. The multiplication factor is adjusted by a control depending on the power of the input signal.

Amplification is often used in conjunction with other circuit functions. Filters often incorporate amplification to boost a desired signal's level while simultaneously rejecting unwanted signals. Attenuators also incorporate amplifiers to expand their dynamic range. Thus an attenuator with gain included can produce an output signal having more or less power than a signal input to the device, depending on the setting. The document US-A-5 587 688 discloses an amplifier with enhanced dynamic range.

Due to inherent amplifier nonlinearities the amplifiers produce distortion. Distortion tends to vary with the signal level presented to an amplifier. Strong input signals tend to increase distortion levels. Often to limit distortion the dynamic range of an amplifier is constrained to a narrow range of input signal levels to prevent distortion from arising. Constraint on signal level affects a receiver system's overall performance.

For example constraint on input levels requires tight automatic gain control ("AGC") of the receiver giving rise to further problems of stability, response time, and maintenance of the required signal level range. Amplifiers with an increased dynamic range are thus desirable in designing receivers to decrease distortion and to relax systems requirements.

SUMMARY OF THE INVENTION

There is therefore provided in a present embodiment of the invention, a large gain range high linearity low noise MOS VGA. An embodiment of the integrated MOS VGA having improved dynamic range comprises a substrate and a first differential pair amplifier disposed upon the substrate. The first differential pair amplifier is driven by a differential input signal, coupled to the VGA output nodes and has a gain that contributes to the VGA gain in direct proportion to the first differential pair amplifier gain.

A second differential pair amplifier disposed upon the substrate is driven by the differential input signal, is inversely coupled to the VGA output nodes with respect to the differential input signal and has a gain. The second differential pair amplifier is coupled to the first differential amplifier such that an increase in the second differential pair amplifier gain contributes to a decrease in the VGA gain.

A variable voltage source is coupled to the VGA output nodes. A voltage output of the variable voltage source determines respective drain voltages on the first differential pair and the second differential pair based on the differential input signal received at the first differential pair amplifier and the second differential pair amplifier. Thereby the gain of the first differential pair and the gain of the second differential pair may be controlled.

DESCRIPTION OF THE DRAWINGS

These and other features and advantages of the present invention will be better understood from the following detailed description read in light of the accompanying drawings, wherein

> FIG. 1 is a block diagram of a variable gain amplifier ("VGA");
> FIG. 2, is a block diagram of the internal configuration of the VGA and the linearization circuit;
> FIG. 3 is a graph of gain versus the control current iSig. Control current iSig is shown as a fraction of iAtten, with the total current being equal to 1, or 100%;
> FIG. 4 is the schematic diagram of an embodiment of the VGA. The VGA has a control circuit to control the Vds of M10 and M13 at node 7505, and the Vds of M4 and M14 at node 7507;
> FIG. 5a illustrates a family of curves showing the relationship of a transistor's drain current ("Id") to its gate source voltage ("Vgs") measured at each of a series of drain source voltages ("Vds") from 50 mV to 1 V;
> FIG. 5b is a graph of gm versus Vgs as Vds is varied from 50 mV to 1 V;
> FIG. 5c is a graph of the cross-section of FIG. 5b plotting gm versus Vds for various values of Vgs;
> FIG. 6 is a schematic of a current steering circuit; and
> FIG. 7 is a schematic of a VD1 control signal generation circuit.

DETAILED DESCRIPTION OF THE INVENTION

The VGA and PGA/LNA have characteristics in common that allow interchangeability in alternative embodiments.

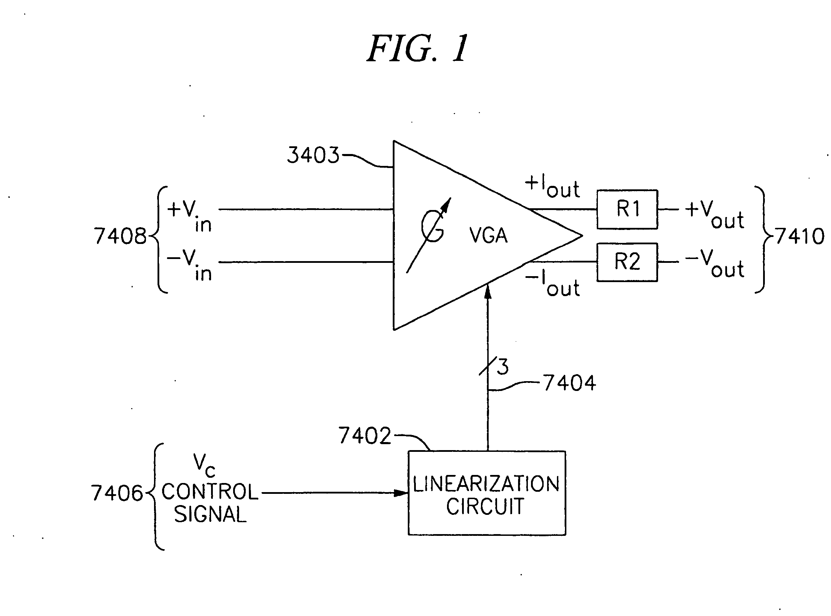

FIG. 1 is a block diagram of a variable gain amplifier ("VGA") 3403. The VGA produces a signal that is a reproduction of a signal input to it at an amplified level. The amplified level in a VGA is capable of being varied. A variable gain is accomplished through the use of one or more control signals applied to the amplifier.

VGAs are frequently used to maintain a constant output signal level. VGAs do this by varying the amplifier gain to compensate for varying input levels. In the case of strong or weak signals it is desirable to maintain a linear gain for input verses output signals with little noise added. Maintenance of a linear gain reduces distortion for high level input signals. VGAs are often used in IF or RF strips to compensate for prior losses or weak signal reception.

In a linear gain, a 1 dB increase in sinusoidal input signal level produces a 1 dB change in the output signal level at that same frequency. A gain of this nature is termed a "linear response." If a 1 dB change is not produced, this is indicative of an available power being diverted to produce a signal at another frequency of operation. A signal at a frequency other than desired often interferes with the signal being amplified and is termed distortion. Thus, the linearity of an amplifier is a figure of merit, the greater the linearity the better the quality of the amplifier. Amplifiers that utilize compensation circuitry and differential signal transmission tend to have improved linearity.

VGA compensation circuitry controls Vds. For a large input signal, linearity and low gain is required. With a reduction in Vds, good linearity and low gain are achieved. If a small signal is input to the amplifier, Vds is increased. The increase in Vds causes one or more MOSFETS internal to the VGA to be biased in the active region. Active region bias allows for high gain and low noise to be achieved simultaneously. The VGA utilizes a current steering method of applying control signals to provide an extended gain range VGA. The control of Vds allows the production of a linear output when a large signal is applied to the input.

The VGA has a differential input comprising two signals, +Vin and -Vin 7408. The VGA has a differential current output comprising two signals, +Iout and -Iout. In the embodiment shown the differential current signals are applied to a first and second resistor R1 and R2 to produce a differential voltage output, +Vout and -Vout 7410 respectively. Equivalently the current outputs may be applied to work against any impedance to generate a voltage output.

A set of three control signals 7404 are supplied to the VGA 3403 from a linearization circuit 7402. The linearization circuit 7402 produces the three control signals 7404 that are derived from a single control signal, Vc 7406 through compensation circuitry. Control signal Vc tends to be proportional to the gain desired in the VGA 3403. The three control signals 7404 control the VGA in a manner such that a desired gain and a desired linearity tend to be produced by the VGA.

The linearization circuit is stimulated by the control signal Vc 7406 is supplied by an external DSP chip. The control signal applied to the linearization circuit 7402 is shaped in a predetermined way. A goal of shaping the control circuit is to produce the second set of control signals 7404 that are applied to the VGA 3403 to produce a desired VGA gain transfer function, measured in decibels, that changes linearly with the applied control signal Vc. In the embodiment shown Vc is a voltage, however a control circuit may be equivalently supplied. In an alternate embodiment the overall transfer function of the VGA is configured to yield a linear function of gain as measured with linear units versus control voltage by appropriately adjusting the linearization circuit through the application of a log to linear conversion current.

In addition to shaping the gain transfer function, another function of the linearization circuit is to control signals that control the VGA to produce the desired low distortion output. The second set of control signals 7404 are shown as a bussed line 7404. The second set of control signals comprise a voltage VD1, and a pair of control currents: iSig and iAtten. The second set of control signals 7404 tend to produce a linear change in gain with variation of the control signal while maintaining an acceptable distortion level in the VGA.

The three control signals are generated by two subcircuits in the linearization circuit: a current steering circuit and a drain voltage control voltage signal generation circuit. The current steering circuit produces two signals, iSig and iAtten. The drain voltage control signal voltage generation circuit produces one signal, VD1.

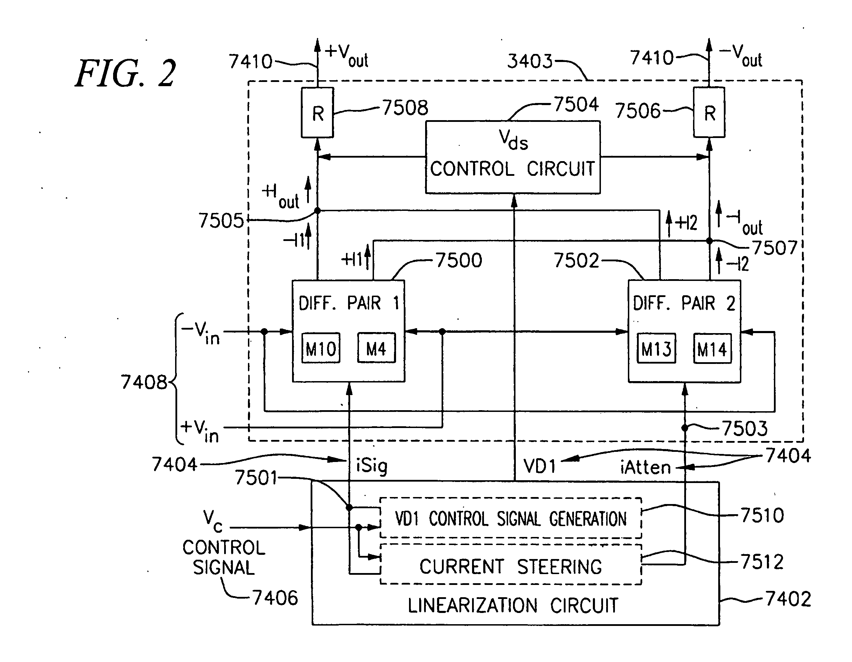

FIG. 2 is a block diagram of the internal configuration of the VGA and the linearization circuit. The VGA and linearization circuit to implement current steering and Vds control of the VGA are described as a separate function block. However, the functions described may be equivalently merged into the circuit functional blocks of the other.

The VGA 3403 is constructed from two cross coupled differential pair amplifiers 7500 7502. A first differential pair amplifier 7500 includes two transistors M4 and M10. A second differential pair amplifier 7502 includes transistors M13 and M14. The first and second differential pair amplifiers are driven in parallel by a differential input voltage 7408. When referenced to ground, the differential input voltage applied to each amplifier simultaneously is denoted +Vin and -Vin.

The differential pair amplifiers have differential current outputs +11, -11, +12, -12, that are combined to produce a differential VGA output comprising +Iout and -Iout. The first differential pair amplifier 7500 has differential current outputs +I1 and -I1 that are sinusoidal and 180 degrees out of phase from each other. The second differential pair amplifier 7502 has differential current outputs +I2 and -12 that are sinusoidal and 180 degrees out of phase from each other. VGA output current +Iout results from the combination at node 7505 of out of phase currents -I1 and +I2. VGA output current -Iout results from the combination at node 7507 of out of phase currents +I1 and - I2. Note that the currents described above having a minus sign prefix, -I1, -12, are generated in response to input voltage -Vin, and the currents with plus sign prefixes, +I1, +I2, are generated in response to +Vin.

A Vds control circuit 7504 within the VGA 3403 supplies a Vds control voltage that is applied to nodes 7505 and 7507. The Vds control circuit receives an input VD1 from a VD1 control signal generation circuit 7510 that is a part of the linearization circuit 7402. In alternative embodiments the Vds control circuit is merged into the VD1 control signal generation circuit 751.

A current steering circuit 7512 in the gain control circuit 7402 supplies control signals iSig and iAtten. The signal iSig is a control input to the first differential pair amplifier 7500. The signal iAtten is a control input to the second differential pair amplifier 7500.

In the embodiment shown the VGA 3403 is configured to operate at an IF frequency. However it is understood that the VGA may be configured, by appropriate component selection to function at any desired frequency. In an IF strip, the addition of a VGA maintains a constant IF output as the input varies. This is accomplished by adjusting the gain of the VGA. A VGA is useful in any situation where a signal presented to a circuit is of unknown or variable strength.

Functionally the VGA maintains a constant level at its output so that subsequent circuitry may be designed that tends to have better performance and less noise. In alternate embodiments, the variable gain amplifier may be used at RF or other frequencies to reduce signal level variations in a circuit. For example in an embodiment, a VGA 3403 as described may be used in the RF front end 3408 to control the RF signal level that is applied to a receiver 3402.

The overall gain of the VGA is attributable to the individual gain contributions of transistors M10 M4, M13 and M14 that produce a current gain. In an embodiment, the VGA voltage gain is set by providing resistance at the +Iout and -Iout terminals to establish a voltage output, and thus a voltage gain for the amplifier. The exemplary embodiment includes field effect transistors ("MOSFETs"). Equivalently, other transistor types may be substituted for the MOSFETs utilized in the exemplary embodiment. A pair of control currents iSig and iAtten and a control voltage VD1 are principally used to provide an extended range of available VGA gain and a linear in dB VGA amplifier transfer function that provides a desired linearity.

Two methods of gain control are utilized in the exemplary VGA. The first method is Vds control that controls noise and linearity while reducing VGA gain when large signals are applied, the second is current steering that provides an extended range of available VGA gain. The set of three control signals 7404 include iSig, iAtten and VD1.

In the first method of Vds control, gain and linearity in the output of the VGA tend to be controlled by adjusting each of four transistors' M4, M10, M13, M14 drain source voltages ("Vds") of the transistors to control a transductance ("gm") associated with each transistor. If a drain source voltage Vds across a MOSFET device M10, M4, M13, M14 is reduced, a gm transfer characteristic of that transistor, which is a function of input voltage, becomes flatter. The flatter the gm transfer function the more linearly the transistor tends to operates. The Vds of all four transistors is controlled in order to manipulate an overall gm characteristic for the VGA.

The Vds gain control method tends to reduce VGA output distortion by tending to improve the linearity of the VGA. To improve the linearity, the Vds of the transistors are reduced yielding better linearity in conjunction with a transistor operating point on a flattened gm curve. As an input signal's strength increases, Vds is reduced providing a linear response VGA. Reducing Vds also tends to contribute to VGA gain control. For small input signals as Vds is increased the MOSFETs become biased in the active region where high gain and low noise operation is obtained. The main effect of reducing Vds tends to be control of the linearity of the VGA amplifier.

In the second method, current steering control, currents iSig and iAtten tend to set amplifier gain over a large range. An increase in the control current iSig tends to increase gain by causing an increase in overall amplifier gm, while an increase in iAtten tends to decrease gain by causing a subtraction of overall amplifier gm. For certain type and size MOSFETs, the relationship between iSig, iAtten and gm is as shown in equation (1)

$$gm = \sqrt{\frac{K}{2}}(\sqrt{iSig} - \sqrt{iAtten}) \qquad (1)$$

where

$$iAtten = Itot - Isig$$

K = a constant of proportionality

For other size/type transistors this relationship may not hold, but the idea is still applicable. The gms of each transistor M10, M4, M13, M14 is controlled to adjust gain. This is accomplished by subtracting, or adding currents through control lines iSig and iAtten to boost or reduce the VGA gm, as required. Control signals iSig and iAtten control amplifier gain by adjusting an overall gm of the amplifier. A fixed available control current is available for controlling VGA gain through the iSig and iAtten control lines. Gain is controlled by selectively steering the available current into the appropriate control line. For large VGA signal inputs, the linearity produced in a VGA from current steering tends to be improved by the addition of the Vds control circuit.

A single stage VGA amplifier with linearization circuitry as described above that utilizes current steering and Vds control could yield a gain control range in excess of 40 dB.

The second method of VGA gain control is Vds control. Linearity in amplifier output tends to be improved by Vds control or "Vds squeezing." With current steering, no provision is made for improving linearity once the input signal becomes large.

Linearity is typically determined by the gm of each of the two differential amplifier stages. The first stage comprises M10 and M4. The second stage comprises M13 and M14. The embodiment described tends to have an increased linearity of 26 dB, corresponding to a factor of 20 improvement in linearity over that typically available.

VGA operating conditions determine the distribution the currents iSig and iAtten. When a small signal is applied to the input terminals +Vin and -Vin, it is typically desirable to amplify the signal with a high gain setting. Transistors M10 and M4 are coupled to the differential output so that their gms tend to contribute to VGA overall gain. However, transistors M13 and M14 are coupled to the VGA output so that their gms tend to decrease VGA gain through a gm subtraction. Transistors M4 and M10 are controlled by iSig, transistors M13 and M14 are controlled by iAtten.

For a high gain condition, gm subtraction is undesired.

Thus, for a high gain setting, it is desirable to have most of the gain available from devices M10 and M4 contributing to the amplifier's overall gain. M10 and M4 are set for maximum gain by setting iSig to a maximum current. Correspondingly iAtten is set to a low value of current. In achieving a maximum gain, a control current is divided between iSig and iAtten such that a maximum current is present in the iSig line.

In the low gain state, the second differential pair transistors M13 and M14 are controlled by iAtten such that they subtract from the gain of M10 and M4. A large gain present for devices M13 and M14 creates a large gain subtraction in devices M10 and M4 which are controlled by iSig to produce a minimum gain.

Thus, when the signal input is small, minimum gain on M13 and M14 is desired and maximum gain on M10 and M4 is desired to produce maximum VGA gain. When the input signal is large, a maximum gain on M13 and M14 is desired and minimum gain on M10 and M4 is desired to produce minimum VGA gain.

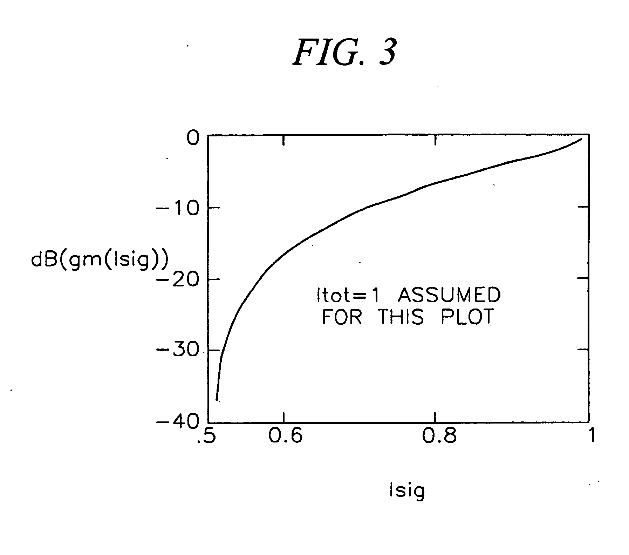

FIG. 3 is a graph of gain versus the control current iSig. Control current iSig is shown as a fraction of iAtten, with the total current being equal to 1, or 100%. At the far right of the graph, a 0 dB reference is set corresponding to maximum amplifier gain of maximum amplifier gm. As iSig is reduced, control current iAtten is increasing proportionately causing the VGA's overall gm and gain to decrease.

Maximum VGA gain is desirable with a small input signal present at the VGA input. Maximum gain is achieved with a maximum current into the iSig control line and minimum current into the iAtten control line. As the signal at the VGA input becomes larger, it is desired to decrease the amplifier gain. A reduction in VGA gain is achieved by decreasing the current in the iSig line and increasing the current in the iAtten control line. A minimum VGA gain corresponds to maximum current in the iAtten control line and minimum current into the iSig line.

Returning to FIG. 2,the linearization circuit takes the externally supplied control signal 7406 that is provided as a voltage and converts it to control signals 7404 that are current and voltage signals. In the current steering circuit 7512 a maximum control signal voltage amplified in the embodiment described corresponds to a maximum gain condition with iSig set to a maximum and iAtten being set to a minimum. As the control voltage is decreased, iSig decreases and iAtten increases.

The control voltage Vc 7406 is created by digital circuitry that is responsive to the input level of the amplifier. In the embodiment described the gain control loop is closed in a digital circuitry domain located off of chip that produces control signal 7404.

The output of the VGA is sampled to determine if sufficient signal strength is available for further signal processing. The sample is processed by an A to D converter into a digital signal, and the control voltage responsive to the level of the VGA output is created. Alternatively, analog methods may be used to sample the output and generate control voltage. In an embodiment the VGA is utilized as an IF VGA. In alternate embodiments the VGA is configured for used at other frequency bands that require an adjustment in gain.

Stability of the AGC loop is maintained during changes in iSig and iAtten. Stability is achieved in the minimum gain setting by keeping iSig greater than iAtten. In the embodiment described iSig is prevented from becoming less than iAtten by the linearization circuit. If iSig becomes less than iAtten, phase inversion problems tend to occur causing a degradation in VGA performance, disrupting automatic gain control ("AGC") loop performance in a receiver. This condition is prevented from happening by providing appropriate circuitry in the linearization circuit.

Also with respect to AGC loop stability, a zero gain setting is undesirable. In the embodiment, the transistors are fabricated with identical dimensions, and it is possible to set the gain equal to zero by making the iSig and iAtten currents equal. This is undesirable from a control loop stability standpoint. The linearization circuit provides appropriate circuitry preventing this condition from occurring.

Maximum attenuation is determined by how close iSig is allowed to approach iAtten in value. Thus, the maximum attenuation achieved is dependent upon the stability that is permissible as iSig approaches iAtten.

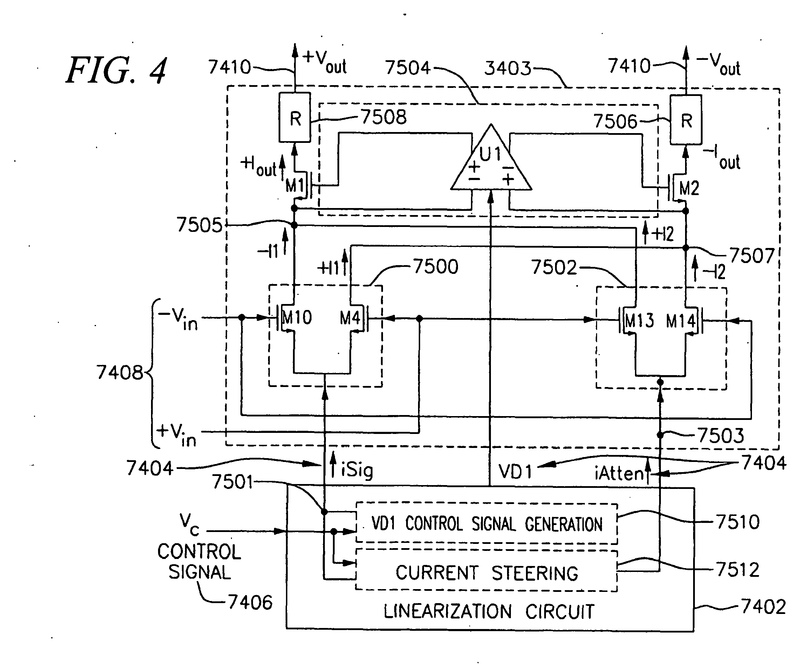

FIG. 4 is the schematic diagram of an embodiment of the VGA. The VGA has a control circuit to control the Vds of M10 and M13 at node 7505, and the Vds of M4 and M14 at node 7507.

A control voltage VD1 is generated by the linearization circuit 7510 and applied to control a differential amplifier U1. The negative input of U1 is coupled to node 7505, and the positive input of U1 is coupled to node 7507.

A transistor M1 has its source coupled to node 7505, its drain comprises the +Iout terminal of the VGA. The gate of transistor M1 is coupled to the positive output of U1. A transistor M2 has its source coupled to node 7507, its drain comprises the -Iout terminal of the VGA. The gate of transistor M2 is coupled to the negative output of A1.

The Vds squeezing is utilized since it tends to improve linearity. As the control signal voltage increases, the control voltage VD1 decreases tending to decrease the VGA gain. As previously discussed, iSig is decreasing and iAtten is increasing to achieve the desired decrease in VGA gain. Concurrently with Vds squeezing, the Vds of all four transistors M10, M4, M13, M14 also tends to decrease with increasing input signal level due to the application of a variable DC voltage at the transistor source leads. A DC voltage is fixed at nodes 7501 and 7503. Thus, the way available to reduce Vds for M10, M4, M13, and M14 is to reduce the DC voltage at the +Iout and -Iout terminals. A variable voltage source is connected at each node +Iout and -Iout - 7505, 7507.

The sources of M13 and M14 are coupled in common to node 7503 and to the control signal iAtten. Control signal iAtten tends to cause a decrease in amplifier gain, while control signal iSig tends to increase amplifier gain. The sources of M10 and M4 are coupled in common to iSig at node 7501. The drains of M10 and M13 are coupled in common to provide an output signal +Iout. The drains of M4 and M14 are coupled in common to provide an output signal -Iout. In the exemplary embodiment input -Vin is coupled to the gates of M10 and M14. Input +Vin is coupled to the gates of M4 and M13. In the exemplary embodiment differential inputs and outputs are shown in the amplifier. However, it is understood by those skilled in the art that a single ended configuration is equivalently produced by the use of a device such as a balun.

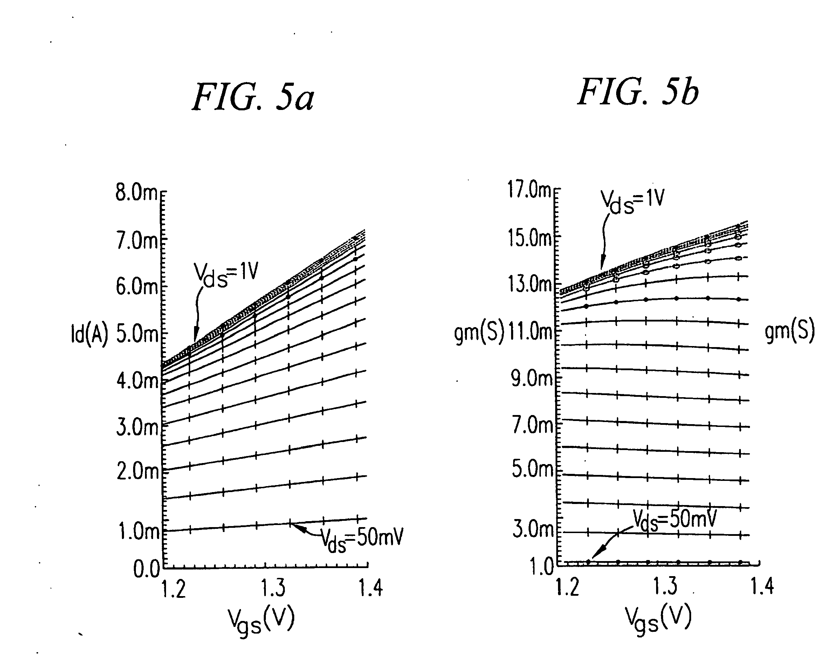

FIG. 5a illustrates a family of curves showing the relationship of a transistor's drain current ("Id") to its gate source voltage ("Vgs") measured at each of a series of drain source voltages ("Vds") from 50 mV to 1 V. From this graph a transconductance, gm is determined. The following relationship defines a gm curve for each Vds value:

$$gm = dId / dVgs \qquad (2)$$

FIG. 5b is a graph of gm versus Vgs as Vds is varied from 50 mV to 1 V. To provide improved output linearity performance, it is desirable to operate a transistor on a curve of gm that has a constant value and zero slope. As seen in the graph for a Vds of approximately 50 mV, the curves of gm verses Vgs tend to be flat. As Vds is increased, the curve begins to slope, indicating the presence of non-linearity in the output signal. As Vds increases the curve not only begins to slope, but it develops a bow, further complicating the compensation for the non-linearities at the higher level of Vds. These irregularities in gm tend to be the sources of non-linearities in the output of the amplifier. Thus, it is desired to provide a flat gm response to produce a more linear transfer function for the VGA by controlling Vds.

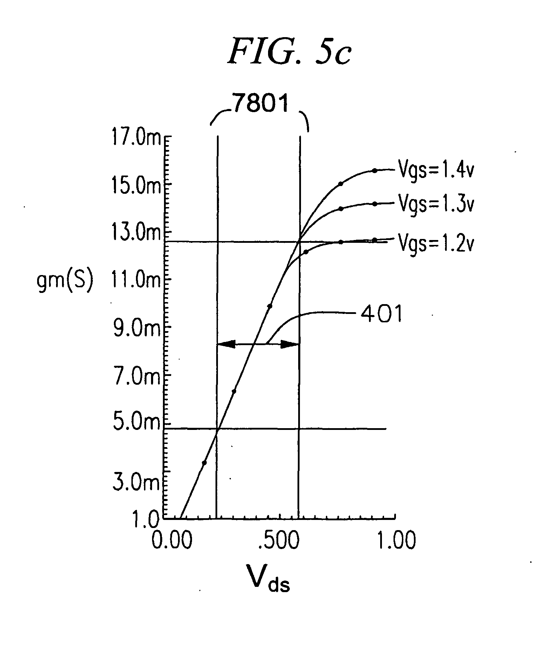

FIG. 5c is a graph of the cross-section of FIG. 5b plotting gm versus Vds for various values of Vgs. As Vds changes from approximately 200 mV to 500 mV, gm changes from approximately 5 mS to 13 mS. The change in gm from 5 mS to 13 mS by changing Vds may be used to control gain. Thus, as Vds is decreased, the gain is decreased. Control of Vds provides approximately 9 dB of gain control range.

Within the range of Vds, graphed between the vertical bars 7801, the value for gm remains essentially the same for a range of Vgs input signal from 1.2 V to 1.4 V. Thus by controlling Vds from 200 mV to 600 mV approximately 9 dB of gain control is provided.

When control of Vds is combined with the gm subtraction method previously described, the linear output signal is maintained. In addition approximately 8 dB to 9 dB of gain control in addition to that provided by gm subtraction contributes to provide overall VGA gain control on the order of 30 dB, in the exemplary embodiment.

Output linearity is often quantitized by measuring an intermodulation product produced by two input signals present at differing frequencies. For the VGA a two tone intermodulation ("IM") product test is utilized, and the distortion as represented by the third order intermodulation product is measured. Approximately a 26 dB decrease in the third order IM product tends to be achieved in the exemplary embodiment.

With the input signal maintained at a constant level, the output signal at +Iout and -Iout is measured as gain squeezing is performed. Improvement is measured as compared to adjusting gain without utilizing gain squeezing. A reduction in third order intermodulation of approximately 25 dB is measured as Vds is squeezed within a range of approximately 150 mV to 200 mV. Utilizing a test having two tones at 44 MHz and 45 MHz typically produces third order intermodulation product components at 43 MHz and 46 MHz. With this test, 20 dB to 25 dB improvement in third order intermodulation is observed in the exemplary embodiment. A typical improvement of 20 dB is realized in the linearity of the output signal.

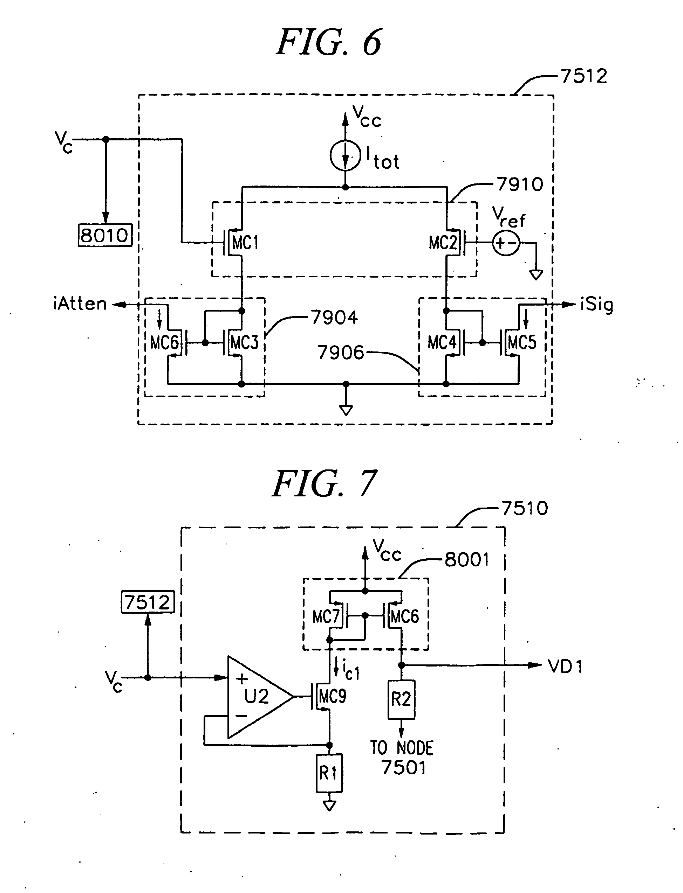

FIG. 6 is a schematic of a current steering circuit. An external control signal Vc drives a differential pair amplifier 7910 including MC1, MC2, to ultimately generate iSig and iAtten. The iSig and iAtten are generated through two current mirrors 7904, 7906. The first current mirror 7904 comprises MC3 and MC6. The second current mirror 7906 comprises MC4 and MC5. The circuit maintains a fixed relationship between iSig and iAtten, defined by:

$$Itot = iSig + iAtten \qquad (3)$$

To guarantee that phase reversal does not occur, iSig must remain greater than iAtten at all times. By selecting Vref to be slightly less than the minimum value of control voltage Vc that will be present, iSig will remain greater than iAtten.

In an embodiment of current steering circuit 7512, a control voltage Vc is applied to a differential pair amplifier 7910. In the exemplary embodiment, control signal Vc ranges from 0.5 V to 2.5 V. The 0.5 V corresponds to a minimum gain setting and 2.5 V corresponds to a maximum gain setting. Differential pair amplifier 7910 comprises two transistors MC1 and MC2. In the exemplary embodiment, field effect transistors are used. Equivalently, other types of transistors may be substituted for field effect devices. The inputs to the differential pair amplifier are the gates of MC1 and MC2. The sources of MC1 and MC2 are coupled in common to a current source Itot. Current source Itot is in turn coupled to a supply voltage Vcc. Current source Itot is conventional current source constructed as is known by those skilled in the art.

The drains of MC1 and MC2 are coupled to current mirrors 7904 and 7906, respectively. Control voltage Vc is coupled to the gate of MC1 and a voltage reference is coupled to the gate of MC2. Voltage reference Vref is typically constructed as conventional voltage source known to those skilled in the art. The currents present in the sources of MC1 and MC2 drive current mirrors 7904 and 7906, respectively. Current mirror 7904 comprises transistors MC6 and MC3. Current mirror 7906 comprises transistors MC4 and MC5. These current mirrors are constructed conventionally as is known by those skilled in the art. Output of current mirror 7904 and 7906 consists of the control signals iAtten and iSig.

FIG. 7 is a schematic of a VD1 control signal generation circuit. Control signal Vc is fed to the positive input of a differential amplifier U2. Signal ended output of amplifier U2 is fed into the gate of transistor MC9. The source of MC9 is connected to the negative input of U2. The source of MC9 is also coupled to a first terminal of a resistor R1. A second terminal of R1 is coupled to ground. The drain of MC9 receives a current ic1 that is supplied by a drain of transistor MC7. The drain of MC7 is coupled to the gate of MC7. The source of MC7 is coupled to a supply voltage Vcc. The gate of MC7 is coupled to the gate of MC6. The source of MC6 is coupled to a supply voltage Vcc. The drain of MC6 is coupled to a first terminal of a resistor R2. The second terminal of resistor R2 is coupled to node 7501. The node formed by coupling MC6 to R2 supplies control signal VD1. Together transistors MC7 and MC6 form a current mirror 8001.

Control voltage Vc sets up the control current ic1 through amplifier U2, resistor R1 and transistor MC9. Current ic1 is mirrored through transistor MC7 and MC8 of the current mirror. The current generated in the drain lead of MC6 creates a voltage across resistor R2 as reference to the voltage present on node 7501. Thus, R1 and R2 are sized properly to control Vds across M10, M4, M13 and M14. For example, VD1 can range from 100 mV to 600 mV. This condition corresponds to a Vc = 0.5V at a minimum gain maximum input condition and a Vc = 2.5V maximum gain minimum input signal condition.

In alternative embodiments, control voltage Vc may be subjected to conditioning by temperature compensation circuitry and linear in dB transfer function compensation before being applied to the VD1 generation circuit 7510.

**Claims**

1. An integrated MOS VGA (3403), comprising:

    a substrate;
    a first differential pair amplifier (7500) disposed upon the substrate and coupled to VGA output nodes (7505, 7507) having a gain contributing to VGA gain in direct proportion to the first differential pair amplifier gain and driven by a differential input signal (7408);
    a second differential pair amplifier (7502) disposed upon the substrate, driven by the differential input signal (7408), inversely coupled to the VGA output nodes (7505, 7507) with respect to the differential input signal (7408), having a gain, and coupled to the first differential amplifier (7500) such that an increase in second differential pair amplifier gain contributes to a decrease in the VGA gain; and
    a variable voltage source (7504) coupled to the VGA output nodes (7505, 7507), a voltage output of the variable voltage source determining respective drain voltages on the first differential pair (M10, M4) and the second differential pair (M13, M14) based on the differential input signal (7408) received at the first differential pair amplifier (7500) and the second differential pair amplifier (7502), and thereby controlling the gain of the first differential pair (M10, M4) and the gain of the second differential pair (M13, M14).

2. The integrated MOS VGA (3403) of claim 1, wherein the variable voltage source (7504) controls the transconductance of the first (7500) and the second differential pair amplifiers (7502).

3. The integrated MOS VGA (3403) of claim 1, wherein the variable voltage source (7504) is configured such that the voltage output of the variable voltage source (7504) is decreased for a large input signal, thereby decreasing the VGA gain while increasing linearity and reducing output distortion.

4. The integrated MOS VGA (3403) of claim 1, wherein the variable voltage source (7504) is configured such that the voltage output of the variable voltage source (7504) is increased for a small differential input signal (7408), causing at least one transistor of the first (7500) and the second differential pair amplifiers (7502) to become biased in an active region, thereby increasing the VGA gain and reducing output distortion.

5. The integrated MOS VGA (3403) of claim 1, further comprising:

    a control signal (VD1) applied to the variable voltage source (7504) to control the voltage output of the variable voltage source (7504).

6. An integrated MOS VGA (3403) as claimed in claim 1, comprising:

    a substrate;
    a first transistor (M10) disposed upon the substrate, the first transistor (M10) having a first transistor gate, a first transistor source, and a first transistor drain, a first transistor drain-source Vds voltage being provided across the first transistor source and the first transistor drain;
    a second transistor (M4) disposed upon the substrate, the second transistor (M4) having a second transistor gate, a second transistor source, and a second transistor drain, a second transistor drain-source Vds voltage being provided across the second transistor source and the second transistor drain;
    a third transistor (M13) disposed upon the substrate, the third transistor (M13) having a third transistor gate, a third transistor source, and a third transistor drain, a third transistor drain-source Vds voltage being provided across the third transistor source and the third transistor drain;

a fourth transistor (M14) disposed upon the substrate, the fourth transistor (M14) having a fourth transistor gate, a fourth transistor source, and a fourth transistor drain, a fourth transistor drain-source Vds voltage being provided across the fourth transistor source and the fourth transistor drain;

the first transistor gate and the fourth transistor gate being responsive to a first input voltage (-Vin), the second transistor gate and the third transistor gate being responsive to a second input voltage (+Vin), the first transistor source being coupled to the second transistor source, the third transistor source being coupled to the fourth transistor source, the second transistor drain being coupled to the fourth transistor drain and the first transistor drain being coupled to the third transistor drain to provide corresponding VGA output nodes (7507, 7505); and

a variable voltage source (7504) coupled to the VGA output nodes (7505, 7507), a voltage output of the variable voltage source (7504) determining respective drain-source Vds voltages on the first (M10), second (M4), third (M13), and fourth transistors (M14) based on a differential input signal (7408) received at the respective gates of the first (M10), second (M4), third (M13), and fourth transistors (M14), thereby controlling a transconductance of each of the first (M10), second (M4), third (M13), and fourth transistors (M14);

wherein the first transistor (M10) and the second transistor (M4) form a first differential pair amplifier (7500) with a first gain, and the third transistor (M13) and the fourth transistor (M14) form a second differential pair amplifier (7502) with a second gain; and

wherein an increase in the first gain contributes to an increase in VGA gain, and an increase in the second gain contributes to a decrease in the VGA gain.

7. The integrated MOS VGA (3403) of claim 6, wherein the variable voltage source (7504) is configured such that the voltage output of the variable voltage source (7504) is decreased for a large differential input signal (7408), thereby decreasing the VGA gain while increasing linearity and reducing output distortion.

8. The integrated MOS VGA (3403) of claim 6, wherein the variable voltage source (7504) is configured such that the voltage output of the variable voltage source (7504) is increased for a small differential input signal (7408), causing at least one of the first (M10), second (M4), third (M13), and fourth transistors (M14) to become biased in an active region, thereby increasing the VGA gain and reducing output distortion.

9. The integrated MOS VGA (3403) of claim 6, further comprising:

a control signal (VD1) applied to the variable voltage source (7504) to control the voltage output of the variable voltage source (7504).

10. A method for providing, over a wide range of input signal voltages, variable gain amplification having a linear change in output current gain at a differential current output port as a function of a change in differential voltage input at a differential voltage input port, comprising the steps of:

providing a variable gain amplifier responsive to the differential voltage input, the variable gain amplifier having:

a first common source differential pair amplifier having output drains;
a second common source differential pair amplifier having output drains,
wherein the first common source differential pair output drains and the second common source differential pair output drains are connected in parallel to form the differential current output port and are responsive to the differential voltage input to provide the output current gain at the differential current output port; and
adjusting first common source differential pair amplifier drain-source Vds voltages and second common source differential pair amplifier drain-source Vds voltages as the differential voltage input changes.

11. The method of claim 10, wherein the step of adjusting includes the step of reducing first common source differential pair amplifier drain-source Vds voltages and second common source differential pair amplifier drain-source Vds voltages as the differential voltage input increases.

12. The method of claim 10, wherein the step of adjusting includes the step of increasing first common source differential pair amplifier drain-source Vds voltages and second common source differential pair amplifier drain-source Vds voltages as the differential voltage input decreases.

13. The method of claim 10, wherein the step of adjusting includes the step of changing absolute direct current voltage at the differential current output port.

**14.** The method of claim 13 wherein the step of changing absolute direct current voltage includes the steps of:

coupling a voltage control source across the differential current output port; and
inputting a gain control signal derived from an input control voltage signal to control the voltage control source to change the absolute direct current voltage at the differential current output port as the differential input voltage changes.

**15.** The integrated MOS VGA (3403) of claim 1, wherein the variable voltage source is configured such that the VGA gain will never become zero.

**16.** An integrated MOS VGA (3403), according to any of the claims 1 - 9 and 15, having improved dynamic range, further comprising:

a fixed control current split between the first differential pair amplifier (7500) and the second differential pair amplifier (7502) such that a current (iAtten) to a second differential pair amplifier source connection is not greater than a current (iSig) applied to a first differential pair amplifier source connection and applied such that an increase in current causes an increase in amplifier gain.

**Patentansprüche**

**1.** Integrierter MOS-Verstärker mit variabler Verstärkung (MOS VGA) (3403), der aufweist:

ein Substrat;
einen ersten Differentialpaar-Verstärker (7500), der auf dem Substrat angeordnet ist und mit VGA-Ausgangsknoten (7505, 7507) gekoppelt ist und eine Verstärkung hat, die zu der VGA-Verstärkung in direktem Verhältnis zu der Verstärkung des ersten Differentialpaar-Verstärkers beiträgt, und von einem differentiellen Eingangssignal (7408) getrieben wird;
einen zweiten Differentialpaar-Verstärker (7502), der auf dem Substrat angeordnet ist, und der von dem differentiellen Eingangssignal (7408) getrieben wird, der invers an die VGA-Ausgangsknoten (7505, 7507) in Bezug auf das differentielle Eingangssignal (7408) gekoppelt ist, eine Verstärkung hat, und an den ersten differentiellen Verstärker (7500) so gekoppelt ist, dass eine Erhöhung der Verstärkung des zweiten Differentialpaar-Verstärkers zu einer Verringerung der VGA-Verstärkung beiträgt; und
eine variable Spannungsquelle (7504), die an die VGA-Ausgangsknoten (7505, 7507) gekoppelt ist, wobei ein Spannungsausgang der variablen Spannungsquelle entsprechende Drain-Spannungen auf dem ersten Differentialpaar (M10, M4) und dem zweiten Differentialpaar (M13, M14) basierend auf dem differentiellen Eingangssignal (7408) bestimmt, das an dem ersten Differentialpaar-Verstärker (7500) und dem zweiten Differentialpaar-Verstärker (7502) empfangen wird, und **dadurch** die Verstärkung des ersten Differentialpaars (M10, M4) und die Verstärkung des zweiten Differentialpaars (M13, M14) steuert.

**2.** Integrierter MOS VGA (3403) nach Anspruch 1, wobei die variable Spannungsquelle (7504) die Transkonduktanz des ersten (7500) und des zweiten (7502) Differentialpaar-Verstärkers steuert.

**3.** Integrierter MOS VGA (3403) nach Anspruch 1, wobei die variable Spannungsquelle (7504) so konfiguriert ist, dass der Spannungsausgang der variablen Spannungsquelle (7504) für ein großes Eingangssignal verringert wird, wodurch die VGA-Verstärkung verringert wird, während die Linearität erhöht und die Ausgangsverzerrung reduziert wird.

**4.** Integrierter MOS VGA (3403) nach Anspruch 1, wobei die variable Spannungsquelle (7504) so konfiguriert ist, dass der Spannungsausgang der variablen Spannungsquelle (7504) für ein kleines differentielles Eingangssignal (7408) erhöht wird, was dazu führt, dass wenigstens ein Transistor des ersten (7500) und des zweiten (7502) Differentialpaar-Verstärkers in einem aktiven Bereich vorgespannt wird, wodurch die VGA-Verstärkung erhöht und die Ausgangsverzerrung reduziert wird.

**5.** Integrierter MOS VGA (3403) nach Anspruch 1, der des Weiteren aufweist:

ein Steuersignal (VD1), das an die variable Spannungsquelle (7504) angelegt wird, um den Spannungsausgang der variablen Spannungsquelle (7504) zu steuern.

**6.** Integrierter MOS VGA (3403) nach Anspruch 1, der aufweist:

ein Substrat;

einen ersten Transistor (M10), der auf dem Substrat angeordnet ist, wobei der erste Transistor (M10) ein erstes Transistor Gate, eine erste Transistor Source und einen ersten Transistor Drain aufweist, wobei eine erste Transistor Drain Source Vds Spannung über die erste Transistor Source und den ersten Transistor Drain bereitgestellt wird;

einen zweiten Transistor (M4), der auf dem Substrat angeordnet ist, wobei der zweite Transistor (M4) ein zweites Transistor Gate, eine zweite Transistor Source und einen zweiten Transistor Drain aufweist, wobei eine zweite Transistor Drain Source Vds Spannung über die zweite Transistor Source und den zweiten Transistor Drain bereitgestellt wird;

einen dritten Transistor (M13), der auf dem Substrat angeordnet ist, wobei der dritte Transistor (M13) ein drittes Transistor Gate, eine dritte Transistor Source und einen dritten Transistor Drain aufweist, wobei eine dritte Transistor Drain Source Vds Spannung über die dritte Transistor Source und den dritten Transistor Drain bereitgestellt wird;

einen vierten Transistor (M14), der auf dem Substrat angeordnet ist, wobei der vierte Transistor (M14) ein viertes Transistor Gate, eine vierte Transistor Source und einen vierten Transistor Drain aufweist, wobei eine vierte Transistor Drain Source Vds Spannung über die vierte Transistor Source und den vierten Transistor Drain bereitgestellt wird;

wobei das erste Transistor Gate und das vierte Transistor Gate auf eine erste Eingangsspannung (-Vin) ansprechen, das zweite Transistor Gate und das dritte Transistor Gate auf eine zweite Eingangsspannung (+Vin) ansprechen, die erste Transistor Source an die zweite Transistor Source gekoppelt ist, die dritte Transistor Source an die vierte Transistor Source gekoppelt ist, der zweite Transistor Drain an den vierten Transistor Drain gekoppelt ist, und der erste Transistor Drain an den dritten Transistor Drain gekoppelt ist, um entsprechende VGA Ausgangsknoten (7507, 7505) bereitzustellen; und

eine variable Spannungsquelle (7504), die an die VGA Ausgangsknoten (7505, 7507) gekoppelt ist, wobei ein Spannungsausgang der variablen Spannungsquelle (7504) entsprechende Drain Source Vds Spannungen auf den ersten (M10), zweiten (M4), dritten (M13) und vierten (M14) Transistoren basierend auf einem differentiellen Eingangssignal (7408) bestimmt, das an den entsprechenden Gates der ersten (M10), zweiten (M4), dritten (M13) und vierten (M14) Transistoren empfangen wird, wodurch die Transkonduktanz jedes der ersten (M10), zweiten (M4), dritten (M13) und vierten (M14) Transistoren gesteuert wird;

wobei der erste Transistor (M10) und der zweite Transistor (M4) einen ersten Differentialpaar-Verstärker (7500) mit einer ersten Verstärkung und der dritte Transistor (M13) und der vierte Transistor (M14) einen zweiten Differentialpaar-Verstärker (7502) mit einer zweiten Verstärkung bilden; und

wobei eine Erhöhung der ersten Verstärkung zu einer Erhöhung der VGA-Verstärkung beiträgt und eine Erhöhung der zweiten Verstärkung zu einer Abnahme der VGA-Verstärkung beiträgt.

**7.** Integrierter MOS VGA (3403) nach Anspruch 6, wobei die variable Spannungsquelle (7504) so konfiguriert ist, dass der Spannungsausgang der variablen Spannungsquelle (7504) für ein großes differentielles Eingangssignal (7408) verringert wird, wodurch die VGA-Verstärkung verringert wird, während die Linerarität erhöht und die Ausgangsverzerrung reduziert wird.

**8.** Integrierter MOS VGA (3403) nach Anspruch 6, wobei die variable Spannungsquelle (7504) so konfiguriert ist, dass der Spannungsausgang der variablen Spannungsquelle (7504) für ein kleines differentielles Eingangssignal (7408) erhöht wird, was dazu führt, dass wenigstens einer der ersten (M10), zweiten (M4), dritten (M13) und vierten (M14) Transistoren in einem aktiven Bereich vorgespannt wird, wodurch die VGA-Verstärkung erhöht und die Ausgangsverzerrung reduziert wird.

**9.** Integrierter MOS VGA (3403) nach Anspruch 6, der des Weiteren aufweist:

ein Steuersignal (VD1), das an die variable Spannungsquelle (7504) angelegt wird, um den Spannungsausgang der variablen Spannungsquelle (7504) zu steuern.

**10.** Verfahren zum Bereitstellen, über einen weiten Bereich von Eingangssignalspannungen, variabler Verstärkung mit einer linearen Veränderung der Ausgangsstromverstärkung an einem differentiellen Strom-Ausgangsport in Abhängigkeit von einer Veränderung des differentiellen Spannungseingangs an einem differentiellen Spannungs-Eingangsport, das die folgenden Schritte umfasst:

Bereitstellen eines Verstärkers mit variabler Verstärkung, der auf den differentiellen Spannungseingang anspricht, wobei der Verstärker mit variabler Verstärkung aufweist:

einen ersten Common-Source Differentialpaar-Verstärker mit der Ausgangs-Drains;
einen Common-Source zweiten Differentialpaar-Verstärker mit Ausgangs-Drains;
wobei die Ausgangs-Drains des ersten Common-Source Differentialpaars und die Ausgangs-Drains des zweiten Common-Source Differentialpaars parallel geschaltet sind, um den differentiellen Strom-Ausgangsport zu bilden, und auf den differentiellen Spannungseingang ansprechen, um die Ausgangsstrom-Verstärkung an dem differentiellen Strom-Ausgangsport bereitzustellen; und
Anpassen der Drain Source Vds Spannungen des ersten Common-Source Differentialpaar-Verstärkers und der Drain Source Vds Spannungen des zweiten Common-Source Differentialpaar-Verstärkers, wenn sich der differentielle Spannungseingang verändert.

11. Verfahren nach Anspruch 10, wobei der Schritt des Anpassens den Schritt des Verringerns der Drain Source Vds Spannungen des ersten Common-Source Differentialpaar-Verstärkers und der Drain Source Vds Spannungen des zweiten Common-Source Differentialpaar-Verstärkers umfasst, wenn sich der differentielle Spannungseingang erhöht.

12. Verfahren nach Anspruch 10, wobei der Schritt des Anpassens den Schritt des Erhöhens der Drain Source Vds Spannungen des ersten Common-Source Differentialpaar-Verstärkers und der Drain Source Vds Spannungen des zweiten Common-Source Differentialpaar-Verstärkers umfasst, wenn sich der differentielle Spannungseingang verringert.

13. Verfahren nach Anspruch 10, wobei der Schritt des Anpassens den Schritt des Veränderns der absoluten Gleichspannung an dem differentiellen Stromausgangsport umfasst.

14. Verfahren nach Anspruch 13, wobei der Schritt des Veränderns der absoluten Gleichspannung die folgenden Schritte umfasst:

Koppeln einer Spannungssteuerungsquelle über dem differentiellen Stromausgangsport; und
Eingeben eines Verstärkungssteuerungssignals, das von einem Eingangssteuerungs-Spannungssignal abgeleitet wurde, um die Spannungssteuerungsquelle zu steuern, um die absolute Gleichspannung an dem differentiellen Stromausgangsport zu verändern, wenn sich die differentielle Eingangsspannung ändert.

15. Integrierter MOS VGA (3403) nach Anspruch 1, wobei die variable Spannungsquelle so konfiguriert ist, dass die VGA-Verstärkung nie Null wird.

16. Integrierter MOS VGA (3403) nach einem der Ansprüche 1 bis 9 und 15 mit einem verbesserten dynamischen Bereich, der des Weiteren aufweist:

einen festgelegten Steuerstrom, der zwischen dem ersten Differentialpaar-Verstärker (7500) und dem zweiten Differentialpaar-Verstärker (7502) so aufgeteilt wird, dass ein Strom (iAtten) zu einer Source-Verbindung des zweiten Differentialpaar-Verstärkers nicht größer ist, als ein Strom (iSig), der an eine Source-Verbindung des ersten Differentialpaar-Verstärkers angelegt wird, und so angelegt wird, dass eine Erhöhung des Stroms zu einer Erhöhung der Verstärkung des Verstärkers führt.

**Revendications**

1. Amplificateur MOS à gain variable intégré (3403), comprenant :

un substrat ;
un premier amplificateur à paire différentielle (7500) disposé sur le substrat et couplé aux noeuds de sortie de l'amplificateur à gain variable (7505, 7507) comportant un gain contribuant au gain de l'amplificateur à gain variable en proportion directe du gain du premier amplificateur à paire différentielle et commandé par un signal d'entrée différentiel (7408) ;
un second amplificateur à paire différentielle (7502) disposé sur le substrat, commandé par le signal d'entrée différentiel (7408), inversement couplé aux noeuds de sortie de l'amplificateur à gain variable (7505, 7507) par rapport au signal d'entrée différentiel (7408), comportant un gain, et couplé au premier amplificateur différentiel (7500) de telle sorte qu'une augmentation du gain du second amplificateur à paire différentielle contribue à une baisse du gain de l'amplificateur à gain variable ; et

une source de tension variable (7504) couplée aux noeuds de sortie de l'amplificateur à gain variable (7505, 7507), une sortie de tension de la source de tension variable déterminant les tensions de drain respectives sur la première paire différentielle (M10, M4) et la seconde paire différentielle (M13, M14) sur la base du signal d'entrée différentiel (7408) reçu par le premier amplificateur à paire différentielle (7500) et par le second amplificateur à paire différentielle (7502), et contrôlant ainsi le gain de la première paire différentielle (M10, M4) et le gain de la seconde paire différentielle (M13, M14).

2. Amplificateur MOS à gain variable intégré (3403) selon la revendication 1, dans lequel la source de tension variable (7504) contrôle la transconductance du premier (7500) et du second amplificateur à paire différentielle (7502).

3. Amplificateur MOS à gain variable intégré (3403) selon la revendication 1, dans lequel la source de tension variable (7504) est configurée de telle sorte que la sortie de tension de la source de tension variable (7504) soit réduite pour un grand signal d'entrée, réduisant ainsi le gain de l'amplificateur à gain variable tout en augmentant la linéarité et réduisant une distorsion de sortie.

4. Amplificateur MOS à gain variable intégré (3403) selon la revendication 1, dans lequel la source de tension variable (7504) est configurée de telle sorte que la sortie de tension de la source de tension variable (7504) soit augmentée pour un signal faible d'entrée différentiel (7408), entraînant la polarisation d'au moins un transistor du premier (7500) et du second amplificateur à paire différentielle (7502) dans une région active, augmentant ainsi le gain de l'amplificateur à gain variable et réduisant une distorsion de sortie.

5. Amplificateur MOS à gain variable intégré (3403) selon la revendication 1, comprenant en outré :

un signal de commande (VD1) appliqué à la source de tension variable (7504) pour contrôler la sortie de tension de la source de tension variable (7504).

6. Amplificateur MOS à gain variable intégré (3403) selon la revendication 1, comprenant :

un substrat ;
un premier transistor (M10) disposé sur le substrat, le premier transistor (M10) comprenant une première grille, une première source, et un premier drain, une première tension Vds drain-source étant fournie à travers la première source et le premier drain dudit premier transistor ;
un deuxième transistor (M4) disposé sur le substrat, le deuxième transistor (M4) comprenant une deuxième grille, une deuxième source, et un deuxième drain, une deuxième tension Vds de drain-source du second transistor étant fournie à travers la deuxième source et le deuxième drain dudit deuxième transistor ;
un troisième transistor (M13) disposé sur le substrat, le troisième transistor (M13) comprenant une troisième grille, une troisième source, et un troisième drain, une troisième tension Vds de drain-source étant fournie à travers la troisième source et le troisième drain dudit troisième transistor ;
un quatrième transistor (M14) disposé sur le substrat, le quatrième transistor (M14) comprenant une quatrième grille, une quatrième source, et un quatrième drain, une quatrième tension Vds de drain-source étant fournie à travers la quatrième source et le quatrième drain dudit quatrième transistor ;
la grille du premier transistor et la grille du quatrième transistor étant réactives à une première tension d'entrée (-Vin), la grille du second transistor et la grille du troisième transistor étant réactives à une seconde tension d'entrée (+Vin), la source du premier transistor étant couplée à la source du second transistor, la source du troisième transistor étant couplée à la source du quatrième transistor, le drain du second transistor étant couplé au drain du quatrième transistor et le drain du premier transistor étant couplé au drain du troisième transistor pour fournir les noeuds de sortie correspondants de l'amplificateur à gain variable (7507, 7505) ; et
une source de tension variable (7504) couplée aux noeuds de sortie de l'amplificateur à gain variable (7505, 7507), une sortie de tension de la source de tension variable (7504) déterminant les tensions Vds de drain-source respectives sur les premier (M10), second (M4), troisième (Ml3), et quatrième transistors (M14) sur la base d'un signal d'entrée différentiel (7408) reçu aux grilles respectives des premier (M10), second (M4), troisième (M13), et quatrième transistors (M14), contrôlant ainsi une transconductance de chacun des premier (M10), second (M4), troisième (Ml3), et quatrième transistors (M14) ;
dans lequel le premier transistor (M10) et le second transistor (M4) forment un premier amplificateur à paire différentielle (7500) avec un premier gain, et le troisième transistor (M13) et le quatrième transistor (M14) forment un second amplificateur à paire différentielle (7502) avec un second gain ; et
dans lequel une augmentation du premier gain contribue à une augmentation du gain de l'amplificateur à gain variable, et une augmentation du second gain contribue à une baisse du gain de l'amplificateur à gain variable.

7.  Amplificateur MOS à gain variable intégré (3403) selon la revendication 6, dans lequel la source de tension variable (7504) est configurée de telle sorte que la sortie de tension de la source de tension variable (7504) soit réduite pour un grand signal d'entrée différentiel (7408), réduisant ainsi le gain de l'amplificateur à gain variable tout en augmentant la linéarité et réduisant la distorsion de sortie.

8.  Amplificateur MOS à gain variable intégré (3403) selon la revendication 6, dans lequel la source de tension variable (7504) est configurée de telle sorte que la sortie de tension de la source de tension variable (7504) soit augmentée pour un petit signal d'entrée différentiel (7408), entraînant la polarisation d'au moins l'un des premier (M10), second (M4), troisième (M13), et quatrième transistors (M14) dans une région active, augmentant ainsi le gain de l'amplificateur à gain variable et réduisant la distorsion de sortie.

9.  Amplificateur MOS à gain variable intégré (3403) selon la revendication 6, comprenant également :

    un signal de commande (VD1) appliqué à la source de tension variable (7504) pour commander la sortie de tension de la source de tension variable (7504).

10. Procédé pour fournir, sur une plage étendue de tensions de signal d'entrée, une amplification à gain variable comportant un changement linéaire dans le gain du courant de sortie à un port de sortie du courant différentiel en fonction d'un changement dans l'entrée de tension différentielle à un port d'entrée de tension différentielle, comprenant les étapes de :

    fourniture d'un amplificateur à gain variable réagissant à l'entrée de tension différentielle, l'amplificateur à gain variable comportant :

        un premier amplificateur à paire différentielle à source commune comportant des drains de sortie ;
        un second amplificateur à paire différentielle à source commune comportant des drains de sortie,
        dans lequel les premiers drains de sortie de paire différentielle à source commune et les seconds drains de sortie de paire différentielle à source commune sont reliés en parallèle pour former le port de sortie du courant différentiel et réagissent à l'entrée de tension différentielle pour fournir le gain du courant de sortie au port de sortie du courant différentiel ; et
        l'ajustement des tensions Vds drain-source du premier amplificateur à paire différentielle à source commune et des tensions Vds drain-source du second amplificateur à paire différentielle à source commune quand l'entrée de tension différentielle change.

11. Procédé selon la revendication 10, dans lequel l'étape d'ajustement comprend l'étape de réduction des tensions Vds drain-source du premier amplificateur à paire différentielle à source commune et des tensions Vds drain-source du second amplificateur à paire différentielle à source commune quand l'entrée de tension différentielle augmente.

12. Procédé selon la revendication 10, dans lequel l'étape d'ajustement comprend l'étape d'augmentation des tensions Vds drain-source du premier amplificateur à paire différentielle à source commune et des tensions Vds drain-source du second amplificateur à paire différentielle à source commune quand l'entrée de tension différentielle diminue.

13. Procédé selon la revendication 10, dans lequel l'étape d'ajustement comprend l'étape de changement de la tension absolue de courant continu du port de sortie du courant différentiel.

14. Procédé selon la revendication 13, dans lequel l'étape de changement de la tension absolue du courant continu comprend les étapes de :

    couplage d'une source de commande de tension à travers le port de sortie du courant différentiel ; et
    entrée d'un signal de commande de gain dérivé d'un signal de tension de commande d'entrée pour commander la source de commande de tension pour changer la tension absolue de courant continu à du port de sortie du courant différentiel quand la tension d'entrée différentielle change.

15. Amplificateur MOS à gain variable intégré (3403) selon la revendication 1, dans lequel la source de tension variable est configurée de telle sorte que le gain de l'amplificateur à gain variable ne devienne jamais nul.

16. Amplificateur MOS à gain variable intégré (3403) selon l'une quelconque des revendications 1 à 9 et 15, comportant une plage dynamique améliorée, comprenant également :

un courant de commande fixe divisé entre le premier amplificateur à paire différentielle (7500) et le second amplificateur à paire différentielle (7502) de telle sorte qu'un courant (iAtten) vers un raccordement de source du second amplificateur à paire différentielle ne soit pas supérieur à un courant (iSig) appliqué à un raccordement de source du premier amplificateur à paire différentielle et appliqué de telle sorte qu'une augmentation du courant entraîne une augmentation du gain de l'amplificateur.

## FIG. 1

**FIG. 2**

# FIG. 3

Itot=1 ASSUMED
FOR THIS PLOT

*FIG. 4*

FIG. 5b

FIG. 5a

## FIG. 5c

# FIG. 6

# FIG. 7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• US 5587688 A